# EUROPÄISCHE PATENTSCHRIFT

(11) **EP 0 609 496 B1**
(45) Veröffentlichungstag und Bekanntmachung des Hinweises auf die Patenterteilung: **15.04.1998**
(21) Anmeldenummer: 93117357.9
(22) Anmeldetag: 26.10.1993
(51) Int. Cl.: H01L 21/768, H01L 21/311

(54) **Verfahren zur Herstellung einer Kontakte und diese verbindende Leiterbahnen umfassenden Metallisierungsebene**
Process of making a metallization stage comprising contacts and runners which canneet these contacts
Procédé de fabrication d'un étage de métallisation comportant des points de contact et des lignes conductrices les reliant

(30) Priorität: 19.01.1993 DE 4301260
(43) Veröffentlichungstag der Anmeldung: 10.08.1994
(73) Patentinhaber: SIEMENS AKTIENGESELLSCHAFT, 80333 München (DE)
(72) Erfinder: Zettler, Thomas, Dr., D-81737 München (DE); Scheler, Ulrich, D-80809 München (DE)

(56) Entgegenhaltungen:
- WO-A-92/09102
- IBM TECHNICAL DISCLOSURE BULLETIN. Bd. 34, Nr. 7A , Dezember 1991 , NEW YORK US Seiten 1 - 2 'DAMASCENE PROCESS FOR SIMULTANEOUSLY INLAYING TUNGSTEN INTO LINES AND CONTACTS'
- MICROELECTRONIC ENGINEERING Bd. 11 , 1990 , AMSTERDAM NL Seiten 531 - 534 M.SEBALD ET AL. 'CHEMICAL AMPLIFICATION OF RESIST LINES (CARL)'

## Beschreibung

Für die Zuverlässigkeit und die Performance von integrierten Schaltungen gewinnt die Verdrahtung mit fortschreitender Miniaturisierung zunehmend an Bedeutung. Bei Verkleinerung der Gatelänge ermöglichen MOS-Transistoren höhere Sättigungsströme. Der maximal zulässige Strom durch einen Kontakt oder durch eine Leiterbahn wird jedoch bei Verkleinerung dessen Querschnitts kleiner.

Insbesondere durch Joulesche Erwärmung in Leiterbereichen mit hohem Widerstand bei hohen Stromdichten entstehen Probleme bei der Verdrahtung. Im Zusammenspiel mit Elektromigration kann die Verdrahtung sogar vollständig zerstört werden (s. z. B. L. A. Miller et al, VMIC 1992 Conf. Proc. 398, IEEE Cat. No. 92ISMIC-101, J. Tao et al, VMIC 1991 Conf. Proc. 390, IEEE Cat. No. 91TH0359-0). Um dieses zu vermeiden, muß in einem Verdrahtungsprozeß, der für Dimensionen im 0,25 µm Bereich geeignet sein soll, wegen der dort auftretenden hohen Stromdichten besonders auf die Vermeidung von hohen und inhomogenen elektrischen Widerständen geachtet werden.

Aus der Literatur sind eine Vielzahl von Verfahren zur Herstellung von Verdrahtungs- oder Metallisierungsebenen bekannt. Eine Metallisierungsebene umfaßt Kontakte und diese Kontakte verbindende Leiterbahnen. Die Kontakte reichen jeweils auf zu kontaktierende Oberflächen in einer darunterliegenden Struktur.

Aus U. Fritsch et al, VMIC 1988, Conf. Proc. 21, IEEE Cat. No. 88CH2624-5 ist bekannt, auf eine Substratoberfläche, die Gateelektroden umfaßt, eine planarisierende SiO₂-Schicht aufzubringen. In der SiO₂-Schicht werden Kontaktlöcher geöffnet.

Darauf wird ganzflächig eine dünne Ti/TiN-Schicht aufgesputtert und die Kontaktlöcher mit Wolfram gefüllt. Darauf werden Leiterbahnen durch ganzflächiges Aufsputtern einer Silizium und Titan enthaltenden Aluminiumschicht und Strukturierung der AlSiTi- und Ti/TiN-Schichten hergestellt. Anschließend wird ganzflächig eine Oxidschicht aufgebracht, die planarisiert wird. In diesem Prozeß entsteht eine Materialgrenzflache zwischen der Kontaktlochfüllung und der Leiterbahn, die zu einem Übergangswiderstand führt.

Aus Uttecht et al, VMIC 1991 Conf. Proc. 20, IEEE Cat. No. 91TH0359-0 ist ein Verfahren zur Herstellung von Verdrahtungsebenen bekannt, in dem die Kontakte unabhängig von den Leiterbahnen hergestellt werden. Die Kontakte werden aus Wolfram und die Leiterbahnen aus einer Aluminiumlegierung gebildet. Zur Erhöhung der Packungsdichte wird in diesem Verfahren zugelassen, daß die Leiterbahnen die Kontakte nur teilweise überdecken. Dadurch wirken sich Justierungenauigkeiten bei der Herstellung der Leiterbahn direkt auf den Querschnitt der Grenzflache Kontakt-Leiterbahn aus. Darüberhinaus kommt es zur Bildung von Übergangswiderständen an dieser Grenzfläche.

Aus C.W. Kaanta et al, VMIC 1991 Conf. Proc. 144, IEEE Cat. No. 91TH0359-0 ist ein Verfahren zur Herstellung einer Verdrahtungsebene bekannt, bei dem sowohl die Kontakte als auch die Leiterbahnen in einem Prozeßschritt durch Abscheidung von Wolfram hergestellt werden. Dadurch wird eine Grenzfläche zwischen den Kontakten und den Leiterbahnen vermieden. Die Leiterbahnen werden anschließend durch Strukturierung der an der Oberfläche befindlichen Wolframschicht gebildet. Bei dieser Strukturierung führt eine Justierungenauigkeit zur Verringerung des gefüllten Kontaktquerschnittes.

Aus J. L. Yeh et al, VMIC 1988 Conf. Proc. 95, IEEE Cat. No. 88CH2624-5 ist ein Verfahren bekannt, bei dem unter Verwendung einer Ätzstoppschicht und zweier Fotolithographieschritte in einer dielektrischen Schicht eine Öffnung erzeugt wird, die das Negative der Kontakte und der Leiterbahnen darstellt. Durch Auffüllung dieser Öffnung mit Metall werden die Kontakte und die Leiterbahnen gebildet. Eine Grenzfläche zwischen Kontakt und Leiterbahn wird dabei vermieden. Der Überlapp Kontakt-Leiterbahn beträgt durch Selbstjustierung 100 %. Die Strukturfeinheit wird jedoch durch Selbstjustierrander der Masken beschränkt. Justierungenauigkeiten führen in diesem Prozeß dazu, daß die Kontakte verengt werden und die Übergangsfläche Leiterbahn-Kontakt verringert wird.

Aus der Entgegenhaltung Yeh et al, VMIC 1988 Conf. Proc. 95, IEEE Cat. No. 88CH2624-5 ist darüberhinaus ein weiteres Verfahren zur Herstellung einer Verdrahtungsebene bekannt. Dabei werden in einer dielektrischen Schicht, die mit einem Ätzstopp versehen ist, Gräben geätzt, die den Verlauf der Leiterbahnen aufweisen. Diese Gräben werden durch eine konform abgeschiedene Metallschicht aufgefüllt. An Stellen, an denen Kontakte gebildet werden sollen, sind die Gräben aufgeweitet, so daß die konform abgeschiedene Metallschicht an diesen Stellen die Gräben nicht vollständig auf füllt. Beim anisotropen Rückätzen der Metallschicht werden in den aufgeweiteten Bereichen die Bodenflächen der Gräben freigelegt, an den Wänden der Gräben entstehen Spacer. Diese Spacer werden als selbstjustierte Ätzmaske zur Herstellung eines Kontaktloches durch Entfernen der dielektrischen Schicht am Boden des Grabens verwendet. Anschließend werden die Kontaktlocher mit Metall aufgefüllt. In diesem Verfahren kann die Packungsdichte nicht beliebig verkleinert werden, da zur Herstellung der Kontakte eine Aufweitung der Leiterbahnen erforderlich ist.

Aus S. Roehl et al, VMIC 1992 Conf. Proc. 22, IEEE Cat. No. 92ISMIC-101 ist ein Verfahren zur Herstellung einer Verdrahtungsebene bekannt, in dem die Kontakte und die Leiterbahnen getrennt hergestellt werden. Dadurch wird eine Grenzfläche gebildet, die zu einem Übergangswiderstand führt. Justierungenauigkeiten wirken sich in diesem Verfahren direkt auf den Überlapp Leiterbahn-Kontakt aus.

Aus C.W. Kaanta et al, VMIC 1991 Conf. Proc. 144, IEEE Cat. No. 91TH0359-0 ist ein Verfahren zur Herstellung einer Verdrahtungsebene bekannt, bei dem auf eine planare Substratoberfläche eine dielektrische Schicht aufgebracht wird, auf die eine Kontaktlochmaske und darauf eine Leiterbahnmaske gebildet werden. Durch schrittweises selektives Ätzen werden zunächst die Kontaktlöcher, und dann, nachdem in einem weiteren Ätzschritt die Struktur der Leiterbahnmaske in die Kontaktlochmaske übertragen worden ist, die Leiterbahnen geätzt. Schließlich werden Kontakte und Leiterbahnen durch Metallabscheidung aufgefüllt. Überlapp zwischen Kontakt und Leiterbahn ist in diesem Verfahren durch Selbstjustierung sichergestellt. Justierungenauigkeiten führen in diesem Verfahren jedoch zu einer Verengung der Kontakte und zu einer Verringerung der Leiterbahn-Kontakt-Übergangsfläche.

Aus US-PS 4 789 648 ist ein Verfahren zur Herstellung einer Verdrahtungsebene bekannt, in dem an der Oberfläche einer dielektrischen Schicht eine Ätzstoppmaske mit Hilfe einer Kontaktlochmaske strukturiert wird. Anschließend wird ganzflächig eine weitere dielektrische Schicht abgeschieden. Mit Hilfe einer Leiterbahnmaske wird die obere dielektrische Schicht strukturiert. Dabei werden auch freiliegende Teile der unteren dielektrischen Schicht weggeätzt. Wegen der Ätzstoppschicht wird das Leiterbahnmuster nur in die obere dielektrische Schicht übertragen. Anschließend werden Kontakte und Leiterbahnen durch Auffüllen mit Metall fertiggestellt. Die Anordnung der Leiterbahnen zu den Kontakten erfolgt selbstjustiert. Justierungenauigkeiten führen jedoch dazu, daß die Kontakte verengt werden, und die Übergangs fläche Leiterbahn-Kontakt verringert wird.

Aus JBM Technical Disclosure Bulletin, vol. 34, No. 7A, December 1991, Seiten 1-2 ist ein Verfahren zur Herstellung einer Verdrahtungsebene bekannt, in dem die Kontaktlöcher während des Ätzschrittes zur Strukturierung der Leiterbahnen bedeckt bleiben.

Der Erfindung liegt das Problem zugrunde, ein Verfahren zur Herstellung einer Metallisierungsebene anzugeben, bei dem eine Grenzfläche zwischen Leiterbahn und Kontakt vermieden wird, bei dem ein 100%iger Überlapp von Leiterbahn und Kontakt sichergestellt ist, bei dem eine Verengung des leitfähigen Kontaktquerschnittes vermieden wird und mit dem die Planarität der Oberfläche erhalten wird.

Dieses Problem wird erfindungsgemäß gelost durch ein Verfahren nach Anspruch 1.

Das Verfahren ist insbesondere geeignet, in einer Mehrlagenverdrahtung für jede Verdrahtungsebene angewendet zu werden. Der Begriff "Kontakt" wird hierbei synonym für den Begriff "Via" verwendet. Der Begriff "Leiterbahn" steht ebenfalls für Metallbahn oder Bahn.

In dem erfindungsgemäßen Verfahren wird auf ein Substrat, das an seiner Oberfläche zu kontaktierende Bereiche umfaßt, ganzflächig eine isolierende Schicht aufgebracht. In der isolierenden Schicht werden Kontaktlöcher geöffnet, in denen die Oberfläche der zu kontaktierenden Bereiche freigelegt wird. Zur Erzeugung einer Leiterbahnmaske wird ganzflächig eine Fotolackschicht aufgebracht, die entsprechend dem Leiterbahnverlauf belichtet wird. Die Fotolackschicht wird anschließend so entwickelt, daß in belichteten Bereichen die Oberfläche der zu kontaktierenden Bereiche in den Kontakt löchern mit Fotolack bedeckt bleibt, wahrend die Oberfläche der isolierenden Schicht in den belichteten Bereichen freigelegt wird. Dieses wird z. B. durch eine entsprechend verkürzte Entwicklungszeit des Fotolacks erreicht.

Unter Verwendung der Leiterbahnmaske als Ätzmaske werden in die isolierende Schicht Gräben geätzt, die eine Tiefe entsprechend der Leiterbahnausdehnung aufweisen. Nach Entfernen der Leiterbahnmaske werden zur Bildung der Kontakte und der Leiterbahnen, die die Metallisierungsebene bilden, die Kontaktlöcher und die Gräben mit Metall aufgefüllt.

Das erfindungsgemäße Verfahren ist besonders vorteilhaft durchzuführen, wenn die Fotolackschicht zur Erzeugung der Leiterbahnmaske aus einem trocken entwickelbaren Lack gebildet wird. In diesem Fall wird der Apparat, in dem die Entwicklung erfolgt, abgeschaltet, sobald eine ausreichende Entwicklung erzielt ist.

In dem erfindungsgemäßen Verfahren wird der leitfähige Kontaktquerschnitt durch die Überlagerung der Kontaktlöcher und der Gräben gebildet. Auf diese Weise wird eine Einengung des leitfähigen Kontaktquerschnittes vermieden und gleichzeitig ein 100%iger Überlapp von Leiterbahn und Kontakt an der Übergangsstelle sichergestellt. Durch Auffüllung der Gräben und der Kontakt löcher in einem Prozeßschritt wird eine Grenzflache zwischen Kontakt und Leiterbahn vermieden. Schließlich sind Kontakt und Leiterbahn prozeßbedingt vollständig in der dielektrischen Schicht vergraben, so daß die Planarität der Oberfläche durch den Prozeß nicht verschlechtert wird.

Zur Auffüllung der Kontakt löcher und Gräben liegt es im Rahmen der Erfindung, ganz flächig eine konforme Metallschicht abzuscheiden, die außerhalb der Leiterbahnen wieder entfernt wird. Weist die isolierende Schicht eine im wesentlichen planare Oberfläche auf ist dazu chemisch mechanisches Polieren, das z. B. aus US-PS 4,944,836 bekannt ist, geeignet.

Weisen die Leiterbahnen in einer Ausdehnung parallel zur Oberfläche des Substrats eine Breite auf, die geringer ist als der doppelte Wert der Tiefe der Gräben, so kann die Metallschicht außerhalb der Kontakte und Leiterbahnen durch maskenloses anisotropes Ätzen entfernt werden.

Weitere Ausgestaltungen der Erfindung gehen aus den übrigen Ansprüchen hervor.

Im folgenden wird die Erfindung anhand eines Ausführungsbeispiels und der Figuren näher erläutert.
- Fig. 1: zeigt ein Substrat mit einer dielektrischen Schicht.
- Fig. 2: zeigt eine Kontaktlochmaske an der Oberfläche der dielektrischen Schicht.
- Fig. 3: zeigt das Substrat nach der Kontaktlochätzung.
- Fig. 4: zeigt das Substrat nach Abscheidung der Fotolackschicht zur Bildung der Leiterbahnmaske.
- Fig. 5: zeigt das Substrat mit der Leiterbahnmaske.
- Fig. 6: zeigt das Substrat nach der Grabenätzung.
- Fig. 7: zeigt das Substrat nach Entfernung der Leiterbahnmaske.
- Fig. 8: zeigt das Substrat nach der Abscheidung einer Metallschicht.
- Fig. 9: zeigt das Substrat nach der Entfernung der Metallschicht außerhalb der Kontaktlöcher und Gräben.
- Fig. 10: zeigt eine Aufsicht auf eine Kontaktlochmaske und eine Leiterbahnmaske, die perfekt zueinander justiert sind.
- Fig. 11: zeigt eine Aufsicht auf eine Kontaktlochmaske und eine Leiterbahnmaske, die gegeneinander dejustiert sind.

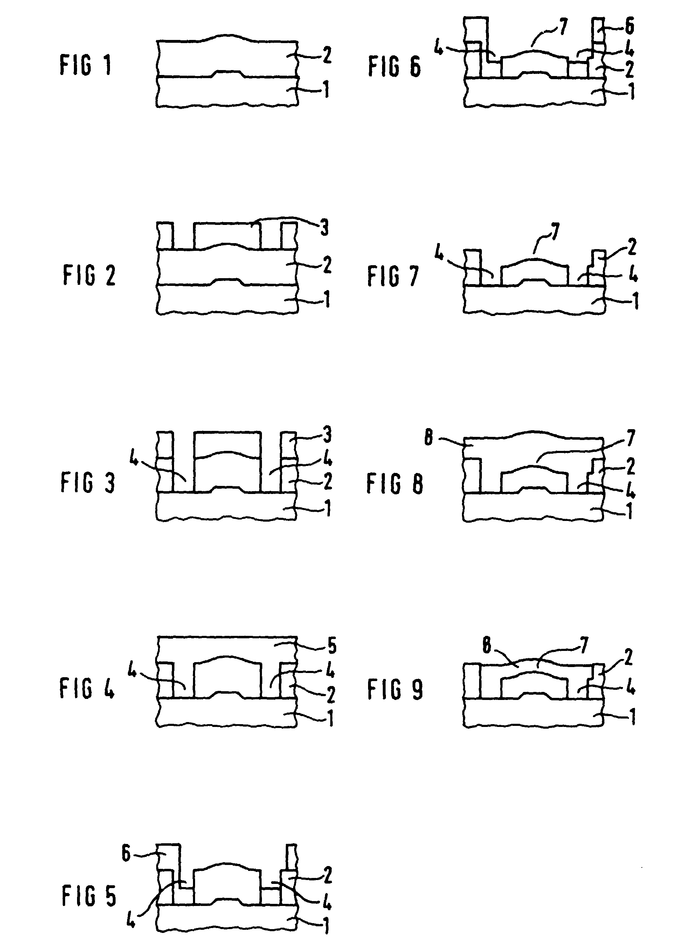

Auf ein Substrat 1, das aktive Schaltelemente umfaßt und dessen Oberfläche zu kontaktierende Bereiche aufweist, wird eine dielektrische Schicht 2 z. B. aus SiO₂ aufgebracht (s. Fig. 1). Die dielektrische Schicht 2 wird z. B. durch Abscheidung von 150 nm dickem, undotiertem CVD-SiO₂ und anschließende Abscheidung von 1200 nm dickem BPSG CVD-SiO₂ und anschließendes Verfließen gebildet. Das Verfließen erfolgt z. B. in einem Kurzzeittemperaturschritt bei 1072°C, während 10 Sekunden.

Auf der dielektrischen Schicht 2 wird eine Kontaktlochmaske 3 erzeugt (s. Fig. 2). Dazu wird z. B. ein Zweischichtlack, wie er aus M. Sebald et al, Microelectronic Engineering 11, 531, 1990 und M. Sebald et al, SPIE Vol. 1262, Advances in Resist Technology and Processing VII, 528, 1990 bekannt ist, verwendet. Ein Zweischichtlack umfaßt einen Bottom-Resist und einen Top-Resist. Die Oberfläche der dielektrischen Schicht 2 wird mit dem Bottom-Resist belackt und ausgeheizt. Anschließend erfolgt das Belacken mit dem Top-Resist. Es folgt eine I-Line-Belichtung, Entwicklung und Silylierung. Anschließend wird die Kontaktlochmaske 3 durch Trockenentwicklung in einem O₂-Plasma fertiggestellt. Die Trockenentwicklung wird z. B. während 180 Sekunden durchgeführt.

Als Bottom-Resist wird z. B. der Typ TSMR-8900 (Hersteller: TOKYO OHKA KOGYO CO. LTD) und als Top-Resist z. B. der Typ CP-365-A (Hersteller: Siemens AG/Hoechst AG) verwendet.

In einem anisotropen Ätzprozeß werden in der dielektrischen Schicht 2 Kontaktlöcher 4 geöffnet (s. Fig. 3). Im Bereich der Kontakt löcher 4 ist die Oberfläche des Substrats 1 freigelegt. Die Kontaktlochätzung erfolgt z. B. in einem CH-F₃/O₂-Plasma während 25 Minuten.

Nach Entfernen der Kontaktlochmaske wird ganzflächig eine Fotolackschicht 5 aufgebracht (s. Fig. 4). Die Fotolackschicht 5 wird z. B. ebenfalls aus einem Zweischichtlacksystem, wie es aus M. Sebald et al, Microelectronic Engineering 11, 531, 1990 und M. Sebald et al, SPIE Vol. 1262, Advances in Resist Technology and Processing VII, 528, 1990 bekannt ist, gebildet. Die Oberfläche der Fotolackschicht 5 ist im wesentlichen planar. Die Fotolackschicht 5 wird durch Belacken mit dem Bottom-Resist, Ausheizen des Bottom-Resist und Belacken mit dem Top-Resist gebildet.

Durch I-Line-Belichtung, Entwicklung und Silylierung und anschließendem Trockenentwickeln in einem 0₂-Plasma wird eine Leiterbahnmaske 6 erzeugt (s. Fig. 5). Die Trockenentwicklung in dem 0₂-Plasma wird dabei nur solange durchgeführt, bis die Oberfläche der isolierenden Schicht im belichteten Bereich freigelegt ist. Am Boden der Kontaktlöcher 4 dagegen verbleibt Fotolack.

Die Leiterbahnmaske 6 kann außer aus dem genannten Fotolack auch aus anderen Fotolacktypen gebildet werden, falls diese sich den Anforderungen entsprechend kontrolliert entwickeln lassen.

Unter Verwendung der Leiterbahnmaske 6 als Ätzmaske wird in einem anisotropen Ätzprozeß der freiliegende Anteil der isolierenden Schicht 2 zurückgeätzt (s. Fig. 6). Dabei entstehen Gräben 7, die die Kontaktlöcher 4 überlappen.

Nach Entfernen der Leiterbahnmaske 6 ist in der isolierenden Schicht 2 ein Kontaktlochmuster und ein Grabenmuster ausgebildet, daß das Negative der herzustellenden Kontakte und Leiterbahnen darstellt. Dieses Muster umfaßt die Überlagerung der Kontaktlochmaske und der Leiterbahnmaske. Bei einer leichten Justierungenauigkeit der Leiterbahnmaske 6 gegenüber dem Kontaktlochrandern, wie es z. B. in Fig. 6 dargestellt ist, bleibt die Weite der einzelnen Kontaktlöcher 4 erhalten (s. Fig. 7). Das links dargestellte Kontaktloch 4, das von der Leiterbahnmaske 6 teilweise überdeckt war (s. Fig. 6) weist im unteren Bereich die gleiche Weite wie das rechts dargestellte Kontaktloch 4 auf. Die Justierungenauigkeit der Leiterbahnmaske 6 am rechten Kontaktloch 4 (s. Fig. 6) wirkt sich als Verbreiterung des Grabens aus. Ein 100%iger Überlapp des Grabens 7 über beide Kontaktlöcher 4 ist in jedem Fall gegeben.

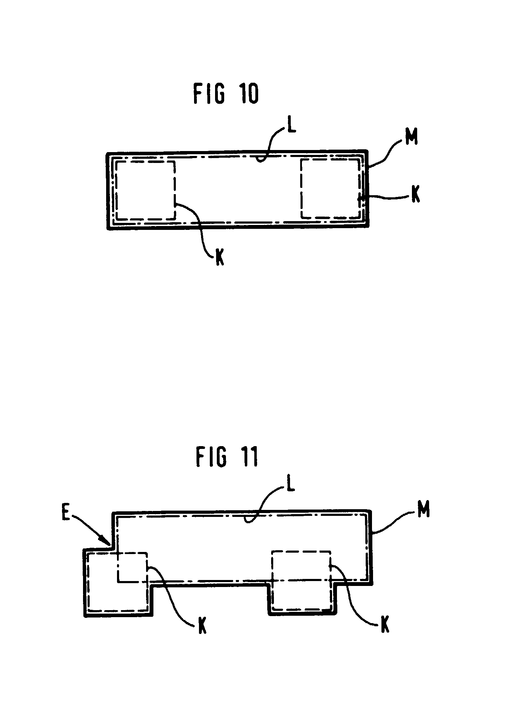

Zur Fertigstellung der Metallisierungsebene folgt das ganzflächige Abscheiden einer konformen Metallschicht 8 (s. Fig. 8). Dazu wird z. B. durch Sputtern eine Haftschicht aus 20 nm Ti und 100 nm TiN aufgebracht. Nach dem Tempern der Haftschicht bei z. B. 715 °C während 20 Sekunden in einer N₂-Atmosphäre folgt eine CVD-Wolframabscheidung.

Zur Fertigstellung der Metallisierungsebene wird die Metallschicht außerhalb der Gräben 7 und der Kontakt löcher 4 rückgeätzt. Die Rückatzung der Metallschicht 8 erfolgt z. B. dadurch, daß unmittelbar nach der Wolframabscheidung in situ in SF₆ rückgeätzt wird. Schließlich wird die Haftschicht rückgeätzt, bis die Oberfläche der isolierenden Schicht 2 außerhalb der Gräben 7 und der Kontaktlöcher 4 freiliegt. Der in den Kontakt löchern 4 verbleibende Anteil der Metallschicht 8 bildet die Kontakte, der in den Gräben 7 verbleibende Anteil der Metallschicht 8 bildet die Leiterbahnen.

Zur Wolframabscheidung ist z. B. der aus K. Koller et al, Applied Surface Science 53, 54, 1991 bekannte Prozeß besonders geeignet.

Anhand von Fig. 10 und 11 wird im folgenden die Überlagerung einer Kontaktlochmaske K und einer Leiterbahnmaske L diskutiert. Die Kontaktlochmaske K ist jeweils durch gestrichelte Konturen dargestellt. Die Leiterbahnmaske L ist durch strichpunktierte Konturen dargestellt. In Fig. 10 ist der Fall dargestellt, daß die Kontaktlochmaske K und die Leiterbahnmaske L ideal zueinander justiert sind. Die Leiterbahnmaske L weist dieselbe Breite auf wie die Kontakt löcher und ist unmittelbar über der Kontaktlochmaske K angeordnet. In dem erfindungsgemäßen Verfahren führt diese Anordnung der Kontaktlochmaske und der Leiterbahnmaske L zu einem Querschnitt der Metallisierung M, der als durchgezeichnete Kontur eingezeichnet ist.

Fig. 11 zeigt den Fall einer gewissen Dejustierung der Kontaktlochmaske K und der Leiterbahnmaske L, was in der Praxis unvermeidlich ist. Die Kontaktlochmaske K ist wiederum als gestrichelte Kontur eingetragen, die Leiterbahnmaske L als strichpunktierte Kontur und der Querschnitt der sich ergebenden Metallisierung als durchgezogene Linie M. Der Querschnitt der Metallisierung M ergibt sich als Überlagerung der Kontaktlochmaske K und der Leiterbahnmaske L. Weder der Querschnitt der Kontaktlochmaske K noch der Querschnitt der Leiterbahnmaske L wird verkleinert. Im Gegenteil, liegt ein Kontaktloch am Rand einer Leiterbahn so wird der Querschnitt der Leiterbahn um das Überragen des Kontaktloches erweitert. In jedem Fall ist ein 100%iger Überlapp zwischen Kontakt und Leiterbahn sichergestellt. Nur in dem Fall, daß ein Kontakt am Ende einer Leiterbahn angeordnet ist, kann es zu einer Einschnürung des Stromflusses kommen, wenn die Leiterbahnmaske gegenüber der Kontaktlochmaske K sowohl in x- als auch in y- Richtung verschoben ist. Dieser Fall ist in Fig. 11 mit dem Pfeil E bezeichnet.

## Patentansprüche

1. Verfahren zur Herstellung einer Kontakte und diese verbindende Leiterbahnen umfassenden Metallisierungsebene,
- bei dem auf ein Substrat (1), das an seiner Oberfläche zu kontaktierende Bereiche umfaßt, ganzflächig eine isolierende Schicht (2) aufgebracht wird,
- bei dem in der isolierenden Schicht (2) Kontaktlöcher (4) geöffnet werden, in denen die Oberfläche der zu kontaktierenden Bereiche freigelegt wird,
- bei dem zur Erzeugung einer Leiterbahnmaske (6) ganzflächig eine Fotolackschicht (5) aufgebracht wird,
- bei dem die Fotolackschicht (5) entsprechend dem Leiterbahnverlauf belichtet und entwickelt wird, wobei in den belichteten Bereichen die Oberfläche der isolierenden Schicht (2) freigelegt wird, während die Oberfläche der zu kontaktierenden Bereiche in den Kontakt löchern mit Fotolack bedeckt bleibt,
- bei dem unter Verwendung der Leiterbahnmaske (6) als Ätzmaske in die isolierende Schicht (2) Gräben (7) geätzt werden, die eine Tiefe entsprechend der Ausdehnung der Leiterbahn senkrecht zur Oberfläche des Substrats (1) aufweisen,
- bei dem nach Entfernen der Leiterbahnmaske (6) zur Bildung der Kontakte und der Leiterbahnen die Kontaktlöcher (4) und die Gräben (7) mit Metall (8) aufgefüllt werden.

2. Verfahren nach Anspruch 1,
bei dem zur Bildung der Kontaktlocher (4) in einem Ätzschritt unter Verwendung einer Kontaktlochmaske (3) als Ätzmaske die isolierende Schicht (2) durchgeätzt wird und bei dem die Kontaktlochmaske (3) vor der Bildung der Leiterbahnmaske (6) entfernt wird.

3. Verfahren nach Anspruch 1 oder 2,
bei dem die Fotolackschicht (5) zur Erzeugung der Leiterbahnmaske (6) aus einem trocken entwickelbaren Lack gebildet wird.

4. Verfahren nach Anspruch 3,
bei dem die Fotolackschicht (5) aus einem Zweischichtsystem mit einer unteren Schicht und einer oberen Schicht gebildet wird, in dem nach der Belichtung die obere Schicht entwickelt und silyliert wird und die untere Schicht trockenentwickelt wird, wobei über die Dauer der Trockenentwicklung die Menge des in den Kontaktlöchern (4) verbleibenden Fotolacks eingestellt wird.

5. Verfahren nach Anspruch 4,
bei dem die Trockenentwicklung in einem O₂-Plasma erfolgt.

6. Verfahren nach Anspruch 4 oder 5,
bei dem die untere Schicht aus einem planarisierenden, absorbierenden und photounempfindlichen Lack und die obere Schicht aus einem photoempfindlichen Lack gebildet werden.

7. Verfahren nach einem der Ansprüche 1 bis 6,
bei dem zur Auffüllung der Kontaktlöcher (4) und Gräben (7) ganzflächig eine konforme Metallschicht (8) abgeschieden wird, die außerhalb der Kontakte und der Leiterbahnen wieder entfernt wird.

8. Verfahren nach Anspruch 7,
bei dem die isolierende Schicht (2) eine im wesentlichen planare Oberfläche aufweist und bei dem die Metallschicht (8) außerhalb der Kontakte und Leiterbahnen durch chemisch-mechanisches Polieren entfernt wird.

9. Verfahren nach Anspruch 7,
bei dem die Leiterbahnen in einer Ausdehnung parallel zur Oberfläche des Substrats (1) eine Breite aufweisen, die geringer ist als der doppelte Wert der Tiefe der Gräben (7) und bei dem die Metallschicht außerhalb der Kontakte und Leiterbahnen durch maskenloses anisotropes Ätzen entfernt wird.

10. Verfahren nach einem der Ansprüche 7 bis 9,
bei dem die Metallschicht (8) durch konforme Abscheidung von Wolfram gebildet wird.

## Claims

1. Method for producing a metallization plane comprising contacts and conductor tracks connecting the latter,
- in which an insulating layer (2) is applied to the whole area of a substrate (1), which comprises regions with which contact is to be made on its surface,
- in which contact holes (4) are opened in the insulating layer (2), in which holes the surface of the regions with which contact is to be made is revealed,
- in which a photoresist layer (5) is applied over the whole area in order to produce a conductor track mask (6),
- in which the photoresist layer (5) is exposed in a manner corresponding to the conductor track course and is developed, the surface of the insulating layer (2) being revealed in the exposed regions, whereas the surface of the regions with which contact is to be made remains covered with photoresist in the contact holes,
- in which trenches (7) are etched into the insulating layer (2) using the conductor track mask (6) as an etching mask, which trenches have a depth corresponding to the extent of the conductor track perpendicularly to the surface of the substrate (1),
- in which, after the removal of the conductor track mask (6), the contact holes (4) and the trenches (7) are filled with metal (8) in order to form the contacts and the conductor tracks.

2. Method according to Claim 1,
in which, in order to form the contact holes (4), the insulating layer (2) is etched through in an etching step using a contact hole mask (3) as an etching mask, and in which the contact hole mask (3) is removed prior to the formation of the conductor track mask (6).

3. Method according to Claim 1 or 2,
in which the photoresist layer (5) for producing the conductor track mask (6) is formed from a resist which can be subjected to dry development.

4. Method according to Claim 3,
in which the photoresist layer (5) is formed from a two-layer system having a bottom layer and a top layer, in which after the exposure, the top layer is developed and silylated and the bottom layer is subjected to dry development, the amount of photoresist remaining in the contact holes (4) being set by way of the duration of the dry development.

5. Method according to Claim 4,
in which the dry development is carried out in an O₂ plasma.

6. Method according to Claim 4 or 5,
in which the bottom layer is formed from a planarizing, absorbing and photo-insensitive resist, and the top layer is formed from a photosensitive resist.

7. Method according to one of Claims 1 to 6,
in which, in order to fill the contact holes (4) and trenches (7), a conformal metal layer (8) is deposited over the whole area and is removed again in the regions not occupied by the contacts and the conductor tracks.

8. Method according to Claim 7,
in which the insulating layer (2) has an essentially planar surface, and in which the metal layer (8) is removed in the regions not occupied by the contacts and conductor tracks by means of chemical mechanical polishing.

9. Method according to Claim 7,
in which the conductor tracks have, in an extent parallel to the surface of the substrate (1), a width which is less than twice the value of the depth of the trenches (7), and in which the metal layer is removed in the regions not occupied by the contacts and conductor tracks by means of maskless anisotropic etching.

10. Method according to one of Claims 7 to 9,
in which the metal layer (8) is formed by conformal deposition of tungsten.

## Revendications

1. Procédé de fabrication d'un étage de métallisation comportant des points de contact et des lignes conductrices les reliant
- dans lequel on applique une couche isolante (2) sur toute la surface d'un substrat (1) comportant des zones à contacter à sa surface,
- dans lequel on ouvre, dans la couche isolante (2), des trous de contact (4) dans lesquels la surface des zones à contacter est mise à nu,
- dans lequel on applique une couche de vernis photosensible (5) sur toute la surface pour produire un masque (6) pour lignes conductrices,
- dans lequel la couche de vernis photosensible (5) est exposée d'une manière correspondante au tracé des lignes conductrices et développée, la surface de la couche isolante (2) étant mise à nu dans les zones exposées tandis que la surface des zones à contacter reste couverte de vernis photosensible dans les trous de contact,
- dans lequel, en utilisant le masque (6) pour lignes conductrices en tant que masque de gravure, on forme, par attaque chimique dans la couche isolante (2), des canaux (7) qui ont une profondeur correspondante à l'étendue des lignes conductrices perpendiculairement par rapport à la surface du substrat (1),
- dans lequel, après l'élimination du masque (6) pour lignes conductrices, les trous de contact (4) et les canaux (7) sont remplis de métal (8) pour former les points de contact et les lignes conductrices.

2. Procédé selon la revendication 1, dans lequel, pour former les trous de contact (4), on perce la couche isolante (2) chimiquement au cours d'une étape d'attaque chimique en utilisant un masque (3) pour trous de contact en tant que masque de gravure, et dans lequel on élimine le masque (3) pour trous de contact avant de former le masque (6) pour lignes conductrices.

3. Procédé selon l'une des revendications 1 ou 2, dans lequel la couche de vernis photosensible (5) destinée à produire le masque (6) pour lignes conductrices est formée d'un vernis pouvant être développé à sec.

4. Procédé selon la revendication 3, dans lequel la couche de vernis photosensible (5) est formée par un système à deux couches avec une couche inférieure et une couche supérieure, dans lequel, après l'exposition, la couche supérieure est développée et silylée et la couche inférieure est développée à sec, la quantité de vernis photosensible restant dans les trous de contact (4) étant déterminée par le biais de la durée du développement à sec.

5. Procédé selon la revendication 4, dans lequel le développement à sec est effectué dans un plasma d'oxygène.

6. Procédé selon l'une des revendications 4 ou 5, dans lequel la couche inférieure est formée par un vernis aplanissant, absorbant et insensible à la lumière et la couche supérieure est formée par un vernis photosensible.

7. Procédé selon l'une des revendications 1 à 6, dans lequel, pour remplir les trous de contact (4) et les canaux (7), on dépose sur toute la surface une couche métallique conforme (8) qui est éliminée à nouveau en dehors des points de contact et des lignes conductrices.

8. Procédé selon la revendication 7, dans lequel la couche isolante (2) a une surface essentiellement plane et dans lequel la couche métallique (8) est éliminée, en dehors des points de contact et des lignes conductrices, par polissage chimique-mécanique.

9. Procédé selon la revendication 7, dans lequel les lignes conductrices ont, dans une étendue parallèle par rapport à la surface du substrat (1), une largeur qui est inférieure au double de la profondeur des canaux (7), et dans lequel la couche métallique est éliminée, en dehors des points de contact et des lignes conductrices, par attaque chimique anisotrope sans masque.

10. Procédé selon l'une des revendications 7 à 9, dans lequel la couche métallique (8) est formée par un dépôt conforme de tungstène.
